Europäisches Patentamt

European Patent Office

Office européen des brevets

(19)

(11) **EP 0 593 982 B1**

(12) **EUROPÄISCHE PATENTSCHRIFT**

(45) Veröffentlichungstag und Bekanntmachung des Hinweises auf die Patenterteilung:
**17.12.1997 Patentblatt 1997/51**

(51) Int Cl.[6]: **H01L 29/86**

(21) Anmeldenummer: **93116212.7**

(22) Anmeldetag: **07.10.1993**

(54) **Si/SiGe BARITT-Diode**

Si/SiGe BARITT-diode

Diode BARITT en Si/SiGe

(84) Benannte Vertragsstaaten:
**DE FR GB**

(30) Priorität: **20.10.1992 DE 4235265**

(43) Veröffentlichungstag der Anmeldung:
**27.04.1994 Patentblatt 1994/17**

(73) Patentinhaber: **Daimler-Benz Aktiengesellschaft 70546 Stuttgart (DE)**

(72) Erfinder:
- **Jorke, Helmut
  D-89547 Gerstetten (DE)**
- **Luy, Johann-Friedrich
  D-89025 Ulm (DE)**

(74) Vertreter: **Fröhling, Werner Otto, Dr. et al Daimler-Benz AG,
Intellectual Property Management,
Sedanstr. 10/Gebäude 17
89077 Ulm (DE)**

(56) Entgegenhaltungen:
**EP-A- 0 262 346**

- **SOLID STATE ELECTRONICS, Bd.25, Nr.9, 1982, OXFORD GB Seiten 943 - 945 S. LURYI ET AL 'Optimum BARITT structure'**
- **ELECTRONICS LETTERS, Bd.24, Nr.22, 27. Oktober 1988, ENAGE GB Seiten 1386 - 1387 J.F. LUY ET AL. 'Si/SiGe heterostructure MITATT diode'**

## Beschreibung

Die Erfindung betrifft eine BARITT-Diode nach dem Oberbegriff des Patentanspruchs 1.

BARITT-Dioden werden in der Hochfrequenztechnik zur Schwingungserzeugung oder als Verstärker verwendet.

BARITT-Dioden sind bekannte Bauelemente und werden bisher ausschließlich auf Siliziumbasis hergestellt. BARITT-Dioden für das Ka-Band (25-40GHz) können Leistungen in einem Bereich von wenigen mW abgeben.

Bei der BARITT-Diode (Barrier-injection transit-time diode) werden Ladungsträger über eine Barriere in ein schmales Halbleitergebiet injiziert. Der Injektionsmechanismus beruht auf thermischer Emission. In dem Halbleitergebiet erfahren die Ladungsträger eine Laufzeitverzögerung, die unter bestimmten Bedingungen zu einem negativen dynamischen Wirkwiderstand führt. BARITT-Dioden arbeiten dann günstig, wenn die Trägerinjektion (Zeitpunkt, Umfang) sorgfältig optimiert wird, insbesondere muß der Stromanstieg nach einer gewissen Durchgreifspannung sehr steil erfolgen. Dann kann der Wirkungsgrad, der üblicherweise unter 1% liegt, deutlich verbessert werden.

Einen höheren Wirkungsgrad erhält man beispielsweise durch eine planare $\delta$-Dotierung der ansonsten undotierten Barrierenschicht einer n$^+$ i p$^+$ in$^+$-BARITT-Diode. Eine theoretische Betrachtung einer $\delta$-dotierten BARITT-Diode wird in einer Veröffentlichung von S. Luryi, R.F. Kazarinov, Solid State Electronics Vol. 25, No. 9, S. 943 (1982) durchgeführt. Die ionisierten Akzeptoren in dem $\delta$-dotierten Bereich der Barrierenschicht bilden eine Potentialbarriere mit einem dreieckigen Verlauf. Um günstige Driftbedingungen der Ladungsträger zu erreichen, muß die Barriere dreieckig sein. Der Bereich mit einer Länge $L_2$ bildet dabei die Driftzone und der Bereich mit einer Länge $L_1$ die Injektionszone. Unter diesen Bedingungen erhält man folgende Zusammenhänge zwischen den Längen $L_1$ und $L_2$ sowie der Driftgeschwindigkeit $v_s$, der Frequenz f und der Stromdichte J

$$L_2 \sim v_{s/f}$$

$$J \sim f/L_1$$

Durch eine günstige Wahl von $L_1$ und $L_2$ sind aufgrund dieser Zusammenhänge eine vorgegebene Schwingungsfrequenz (>40GHz) und eine vorgegebene Gleichstromdichte J einstellbar.

Aufgabe der Erfindung ist es eine BARITT-Diode für den oberen mm-Wellenbereich anzugeben, die einen guten Wirkungsgrad aufweist und technisch einfach und kostengünstig herstellbar ist.

Die Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen zu entnehmen.

Die Erfindung wird anhand eines Ausführungsbeispiels beschrieben unter Bezugnahme auf schematische Zeichnungen.

FIG. 1a zeigt einen möglichen Schichtaufbau einer BARITT-Diode.

FIG. 1b gibt den Ge-Gehalt der BARITT-Diodenstruktur an.

FIG. 2 gibt den Verlauf des Leitungsbandminimums in einer pseudomorphen Si/SiGe-BARITT-Struktur an.

Die Erfindung hat den Vorteil, daß eine pseudomorph auf einem Si-Substrat aufgewachsene SiGe-Schicht die Driftzone der BARITT-Diode bildet. Die SiGe-Schicht ist aufgrund einer größeren Gitterkonstante als Si kompressiv verspannt, was eine deutlich höhere Sättigungsdriftgeschwindigkeit der Ladungsträger als in einer unverspannten SiGe- oder Si-Schicht bewirkt. Eine höhere Driftgeschwindigkeit gestattet eine längere Driftzone. Eine große Driftzone verringert die Kapazität der Diode und dies wiederum steigert das Leistungsvermögen der Diode bei sehr hohen Arbeitsfrequenzen.

Desweiteren bewirkt die Ausgestaltung der BARITT-Diode mit einem planar $\delta$-dotierten aktiven SiGe-Bereich, daß bei hohen Arbeitsfrequenzen (>40GHz) ein höherer Wirkungsgrad erzielt wird als mit herkömmlichen BARITT-Strukturen (n$^+$ p n$^+$ oder p$^+$ n p$^+$). So erzielt man beispielsweise bei einer Arbeitsfrequenz von 70 GHz Leistungen bis zu 10mW.

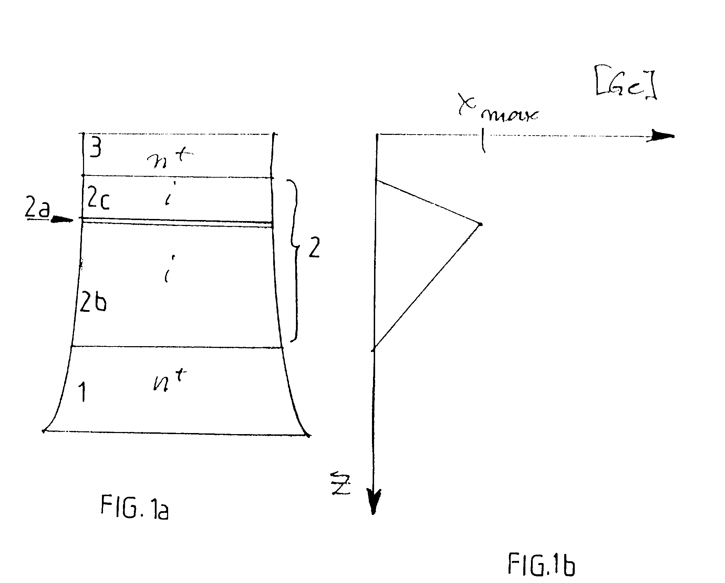

In FIG. 1a ist ein Ausführungsbeispiel einer erfindungsgemäßen Halbleiterstruktur einer BARITT-Diode dargestellt. Auf einem n$^+$-dotierten Si-Substrat 1 mit einer Ladungsträgerkonzentration von etwa $10^{20}$cm$^{-3}$ und einer Schichtdicke von ca. 5$\mu$m, ist eine im wesentlichen undotierte SiGe-Schicht 2 pseudomorph aufgewachsen, die eine p$^+$-$\delta$-dotierte dünne Halbleiterzone 2a enthält. Die $\delta$-dotierte Zone beträgt etwa 1 bis 10nm und ist mit etwa $10^{12}$ Akzeptoren/cm$^2$ dotiert. Als Dotiermaterialien werden z.B. B oder Ga verwendet. Die dotierte Zone 2a ist derart in die SiGe-Schicht 2 eingebracht, daß unterhalb der $\delta$-dotierten Zone 2a eine etwa $L_2$ = 1-2$\mu$m dicke i-SiGe-Schicht 2b und oberhalb der $\delta$-dotierten Zone 2a eine ca. $L_1$ = 30nm dünne i-SiGe-Schicht 2c verbleibt.

Auf die SiGe-Schicht 2 ist eine ca. 0,1$\mu$m dicke n$^+$-dotierte Si-Schicht 3 abgeschieden, mit einer Ladungsträgerkonzentration von $10^{20}$cm$^{-3}$. Die Schichten 1 und 3 bilden die Kathode bzw. Anode der BARITT-Diode. Die Schicht 2 bildet die Barrierenschicht, die wiederum in die Injektionszone 2c und die Driftzone 2b der BARITT-Diode aufgeteilt ist.

Durch die Bedingung $L_1 \ll L_2$ erreicht man einen

asymmetrischen Potentialverlauf in der SiGe-Schicht 2.

Die SiGe-Schicht 2 besitzt außerdem einen Ge-Gehalt x, der von der Si-Schicht 1 bis zur δ-dotierten Zone 2a z.B. auf x = 10% kontinuierlich zunimmt. Von der δ-dotierten Zone 2a bis zur Si-Schicht 3 wird der Ge-Gehalt der SiGe-Schicht 2 wieder auf x = o reduziert (FIG. 1b).

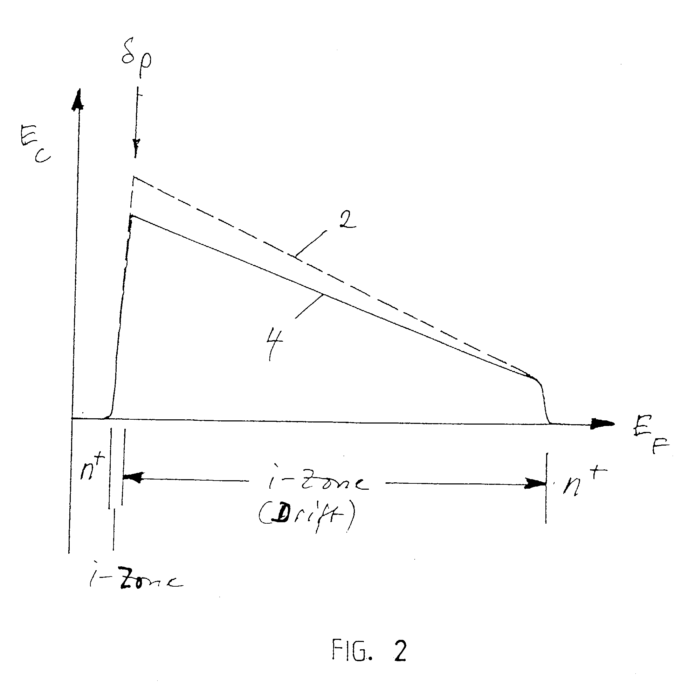

Außer durch die δ-Dotierung wird auch durch die Verwendung einer pseudomorph auf einer Si-Schicht gewachsenen SiGe-Schicht als Driftzone 2b die Driftgeschwindigkeit erhöht. Durch die Druckspannung in der SiGe-Schicht findet eine Aufspaltung des 6-fach entarteten X-Leitungsbandminimums in der SiGe-Schicht statt. Elektronen werden aus der Injektionszone 2c bevorzugt - aufgrund der geringeren Barrierenhöhe - in das 4-fach entartete Minimum der Driftzone 2b injiziert (FIG. 2). Durch die Anisotropie der X-Leitungsbandminima besitzen die Ladungsträger des 4-fach entarteten X-Minimums eine kleinere effektive Masse in Driftrichtung als die Ladungsträger des 2-fach entarteten X-Minimums. (Ch. Zeller, G. Abstreiter, Z. Phys. B, Cand. Mat. 64, S.137 (1986)).

Eine Folge dieser Anisotropie in Verbindung mit der energetischen Aufspaltung des 6-fach entarteten X-Leitungsbandminimums in der pseudomorph gewachsenen SiGe-Schicht ist eine höhere Sättigungsdriftgeschwindigkeit $v_s$ in der pseudomorph gewachsenen SiGe-Schicht als in einer unverspannten SiGe- oder Si-Schicht. Die Bewegung der Ladungsträger erfolgt senkrecht zu der biaxialen Verspannung in der SiGe-Schicht.

Eine höher Driftgeschwindigkeit $v_s$ gestattet jedoch auch eine längere Driftzone, was wiederum zu einer Kapazitätsverringerung der Diode führt. Durch die geringere Kapazität der Diode kann das Leistungsvermögen der Diode bei sehr hohen Arbeitsfrequenzen gesteigert werden.

Mit der im Ausführungsbeispiel angegebenen BARITT-Diode werden für Arbeitsfrequenzen von ca. 70GHz Ströme von ca. 50mA, sowie Leistungen bis zu 10mW erreicht. Es werden Wirkungsgrade von über 2% erzielt.

Die Erfindung ist nicht auf die im Ausführungsbeispiel angegebene Struktur der BARITT-Diode begrenzt, sondern auch auf andere Strukturen z.B. p⁺in⁺ip⁺ anwendbar.

Auch die Dotierungen insbesondere der Barrierenschicht können mit anderen Materialien und Konzentrationen durchgeführt werden. Außerdem ist die Länge $L_2$ der Driftzone insoweit einstellbar, daß je nach Ge-Gehalt der SiGe-Schicht 2 eine andere unterkritische Schichtdicke für das pseudomorphe Wachstum gewählt werden kann.

**Patentansprüche**

1. BARITT-Diode, die aus einer Heterostruktur-Halbleiterschichtenfolge aufgebaut ist, die eine sehr dünne hochdotierte Halbleiterschicht enthält, dadurch gekennzeichnet, daß die Heterostruktur aus einer pseudomorph gewachsenen Si/SiGe-Halbleiterschichtenfolge besteht, und daß die sehr dünne hochdotierte Halbleiterschicht aus einer planaren δ-Dotierung der SiGe-Schicht besteht.

2. BARITT-Diode nach Anspruch 1, dadurch gekennzeichnet, daß die Halbleiterschichtenfolge zumindest aus

   - einer n⁺-dotierten Si-Schicht (1)
   - einer gering dotierten oder undotierten SiGe-Schicht (2), die eine δ-dotierte p⁺-Zone (2a) enthält, und
   - einer n⁺-dotierten Si-Schicht (3)

   besteht.

3. BARITT-Diode nach Anspruch 2, dadurch gekennzeichnet, daß die SiGe-Schicht (2) eine Injektionszone (2c) der Länge $L_1$ und eine Driftzone (2b) der Länge $L_2$ enthält, die durch die p⁺-Zone (2a) getrennt sind, und daß für die Länge $L_1$ und $L_2$ der Injektionszone (2c) und Driftzone (2b) gilt: $L_1 \ll L_2$.

4. BARITT-Diode nach einem der vorhergehenden Ansprüche, dadurch gekennzeichnet, daß die δ-dotierte Zone (2a) in einem Bereich von 1 bis 10nm eine Ladungsträgerkonzentration von $10^{12}$ Akzeptoren/cm² besitzt.

5. BARITT-Diode nach einem der vorhergehenden Ansprüche, dadurch gekennzeichnet, daß die Länge der Injektionszone (2c) ca. $L_1$ = 30nm und die Länge der Driftzone (2b) $1\mu m < L_2 < 2\mu m$ beträgt.

6. BARITT-Diode nach einem der vorhergehenden Ansprüche, dadurch gekennzeichnet, daß die SiGe-Schicht (2) pseudomorph auf die n⁺-dotierte Si-Schicht (1) aufgewachsen ist, daß die Sättigungs-Driftgeschwindigkeit $v_s$ in der pseudomorph gewachsenen SiGe-Schicht höher ist als in einer vergleichsweise unverspannten Si- oder SiGe-Schicht, daß durch die höhere Sättigungsgeschwindigkeit $v_s$ eine längere Driftzone herstellbar ist und daß die Verlängerung der Driftzone, eine Verringerung der Kapazität der Diode bewirkt.

7. BARITT-Diode nach einem der vorhergehenden Ansprüche, dadurch gekennzeichnet, daß die SiGe-Schicht (2) einen Ge-Gehalt besitzt, der von der Si-Schicht (1) bis zur δ-dotierten Zone (2a) kontinuierlich zunimmt und von der δ-dotierten Zone (2a) bis zur Si-Schicht (3) wieder auf Null reduziert wird.

## Claims

1. BARRIT diode, which is built up from a heterostructure semiconductor layer sequence which contains a very thin, highly doped semiconductor layer, characterised thereby that the heterostructure consists of a pseudomorphically grown Si/SiGe semiconductor layer sequence and that the very thin, highly doped semiconductor layer consists of a planar, $\delta$ doping of the SiGe layer.

2. BARRIT diode according to claim 1, characterised thereby that the semiconductor layer sequence consists of

   - an n+ doped Si layer (1),
   - a slightly doped or an undoped SiGe layer (2), which contains a $\delta$ doped p+ zone (2a), and
   - an n+ doped Si layer (3).

3. BARRIT diode according to claim 2, characterised thereby that the SiGe layer (2) contains an injection zone (2c) of the length $L_1$ and a drift zone (2b) of the length $L_2$, which are separated by the p+ zone (2a), and that $L_1 \ll L_2$ applies to the lengths $L_1$ and $L_2$ of the injection zone (2c) and drift zone (2b).

4. BARRIT diode according to one of the preceding claims, characterised thereby that the $\delta$ doped zone (2a) has a charge carrier concentration of $10^{12}$ acceptors/cm$^2$ in a region of 1 to 10 nm.

5. BARRIT diode according to one of the preceding claims, characterised thereby, that the length of the injection zone (2c) amounts to about $L_1 = 30$nm and the length of the drift zone (2b) to $1\mu m < L_2 < 2\mu m$.

6. BARRIT diode according to one of the preceding claims, characterised thereby, that the SiGe layer (2) is pseudomorphically grown on the n+ doped Si layer (1), that the saturation drift speed $v_s$ in the pseudomorphically grown SiGe layer is higher than in a comparatively unstressed Si or SiGe layer, that a longer drift zone is producible by the higher saturation speed $v_s$ and that the prolongation of the drift zone effects a reduction in the capacity of the diode.

7. BARRIT diode according to one of the preceding claims, characterised thereby, that the SiGe layer (2) has a Ge content which continuously increases from the Si layer (1) to the $\delta$ doped zone (2a) and reduces back down to zero from the $\delta$ doped zone (2a) to the Si layer (3).

## Revendications

1. Diode BARITT, constituée d'une succession de couches semiconductrices à hétérostructure, qui contient une couche semiconductrice fortement dopée très mince, caractérisée en ce que l'hétérostructure se compose d'une succession de couches semiconductrices Si/SiGe obtenue de façon pseudomorphe et en ce que la couche semiconductrice fortement dopée, très mince, se compose d'une couche SiGe à dopage $\delta$ planaire.

2. Diode BARITT selon la revendication 1, caractérisée en ce que la succession de couches semiconductrices se compose d'au moins

   - une couche Si dopée n+ (1)
   - une couche SiGe faible dopée ou non dopée (2), qui contient une zone p+ dopée-$\delta$ (2a), et
   - une couche Si dopée n+ (3).

3. Diode BARITT selon la revendication 2, caractérisée en ce que la couche SiGe (2) contient une zone d'injection (2c) de longueur $L_1$ et une zone de dérive (2b) de longueur $L_2$ qui sont séparées par la zone p+ (2a), et en ce que pour les longueurs $L_1$ et $L_2$ de la zone d'injection (2c) et de la zone de dérive (2b) s'applique : $L_1 \ll L_2$.

4. Diode BARITT selon l'une quelconque des revendications précédentes, caractérisée en ce que la zone dopée-$\delta$ (2a) possède dans une zone de 1 à 10 nm une concentration de porteurs de charge de $10^{12}$ accepteurs/cm$^2$.

5. Diode BARITT selon l'une quelconque des revendications précédentes, caractérisée en ce que la longueur de la zone d'injection (2c) s'élève à environ $L_1 = 30$ nm et la longueur de la zone de dérive (2b) s'élève à $1\ \mu m < L_2 < 2\ \mu m$.

6. Diode BARITT selon l'une quelconque des revendications précédentes, caractérisée en ce que la couche SiGe (2) est obtenue de façon pseudomorphe sur la couche Si dopée n+ (1), en ce que la vitesse de dérive à saturation $v_s$ dans la couche SiGe pseudomorphe est plus élevée que dans une couche Si ou SiGe relativement sans contrainte, en ce que grâce à la vitesse de saturation $v_s$ accrue peut être obtenue une zone de dérive plus longue et en ce que l'allongement de la zone de dérive provoque une réduction de la capacité de la diode.

7. Diode BARITT selon l'une quelconque des revendications précédentes, caractérisée en ce que la couche SiGe (2) possède une teneur en Ge, qui croît continûment depuis la couche Si (1) jusqu'à la zone dopée-$\delta$ (2a) et est réduite à nouveau à zéro depuis la zone dopée-$\delta$ (2a) jusqu'à la couche Si (3).

EP 0 593 982 B1

FIG. 1a

FIG.1b

FIG. 2